(19) **Europäisches Patentamt**
**European Patent Office**
**Office européen des brevets**

(11) **EP 1 768 846 B1**

(12) **EUROPEAN PATENT SPECIFICATION**

(45) Date of publication and mention
of the grant of the patent:
**11.08.2010 Bulletin 2010/32**

(51) Int Cl.:
**G02F 1/1333** (2006.01)

(21) Application number: **05757163.0**

(86) International application number:
**PCT/US2005/019509**

(22) Date of filing: **02.06.2005**

(87) International publication number:
**WO 2005/120834 (22.12.2005 Gazette 2005/51)**

(54) **FLUID DISPENSING AND DROP-ON-DEMAND DISPENSING FOR NANO-SCALE MANUFACTURING**

FLUIDAUSGABE UND TROPFENAUSGABE NACH BEDARF FÜR DIE HERSTELLUNG IM NANOBEREICH

DISTRIBUTION DE FLUIDE ET DISTRIBUTION DE GOUTTES A LA DEMANDE POUR UNE FABRICATION A L'ECHELLE DU NANOMETRE

(84) Designated Contracting States:
**AT BE BG CH CY CZ DE DK EE ES FI FR GB GR HU IE IS IT LI LT LU MC NL PL PT RO SE SI SK TR**

(30) Priority: **03.06.2004 US 576878 P**

(43) Date of publication of application:
**04.04.2007 Bulletin 2007/14**

(73) Proprietor: **MOLECULAR IMPRINTS, INC.**
**Austin, TX 78758-3605 (US)**

(72) Inventors:
 • **LAD, Pankaj, B.**
   **Austin, Texas 78757 (US)**
 • **MCMACKIN, Ian, M.**
   **Austin, Texas 78731 (US)**
 • **TRUSKETT, Van, N.**
   **Austin, Texas 78731 (US)**
 • **SCHUMAKER, Norman, E.**
   **Austin, Texas 78735 (US)**
 • **SREENIVASAN, Sidlgata, V.**
   **Austin, Texas 78750 (US)**
 • **VOTH, Duane**
   **Austin, Texas 78728 (US)**
 • **SCHUMAKER, Philip, D.**
   **Austin, Texas 78735 (US)**
 • **FLETCHER, Edward, B.**
   **Austin, Texas 78729 (US)**

(74) Representative: **Peterreins, Frank et al**
**Fish & Richardson P.C.**
**Highlight BusinessTowers**
**Mies-van-der-Rohe-Strasse 8**
**80807 München (DE)**

(56) References cited:
**EP-A- 1 254 704          WO-A- 02/06902**
**US-A1- 2003 001 992     US-B2- 6 870 584**

 • **XU F ET AL: "Development of imprint materials for the step and flash imprint lithography process" PROCEEDINGS OF THE SPIE - THE INTERNATIONAL SOCIETY FOR OPTICAL ENGINEERING SPIE-INT. SOC. OPT. ENG USA, vol. 5374, no. 1, May 2004 (2004-05), pages 232-241, XP002456072 ISSN: 0277-786X**

**Description**

BACKGROUND OF THE INVENTION

The field of the invention relates generally to imprint lithography. More particularly, the present invention is directed to a method of dispensing a volume of a liquid on a substrate to reduce the time required to fill the features of a template during imprint lithography processes.

Micro-fabrication involves the fabrication of very small structures, e.g., having features on the order of micrometers or smaller. One area in which micro-fabrication has had a sizeable impact is in the processing of integrated circuits. As the semiconductor processing industry continues to strive for larger production yields while increasing the circuits per unit area formed on a substrate, micro-fabrication becomes increasingly important. Micro-fabrication provides greater process control while allowing increased reduction of the minimum feature dimension of the structures formed. Other areas of development in which micro-fabrication has been employed include biotechnology, optical technology, mechanical systems and the like.

An exemplary micro-fabrication technique is shown in United States patent number 6,334,960 to Willson et al. Willson et al. disclose a method of forming a relief image in a structure. The method includes providing a substrate having a transfer layer. The transfer layer is covered with a polymerizable fluid composition. A mold makes mechanical contact with the polymerizable fluid. The mold includes a relief structure, and the polymerizable fluid composition fills the relief structure. The polymerizable fluid composition is then subjected to conditions to solidify and to polymerize the same, forming a solidified polymeric material on the transfer layer that contains a relief structure complimentary to that of the mold. The mold is then separated from the solid polymeric material such that a replica of the relief structure in the mold is formed in the solidified polymeric material. The transfer layer and the solidified polymeric material are subjected to an environment to selectively etch the transfer layer relative to the solidified polymeric material such that a relief image is formed in the transfer layer. The time required and the minimum feature dimension provided by this technique are dependent upon, *inter alia*, the composition of the polymerizable material.

Document WO0206902 and paper "Development of imprint materials for the step and flash imprint lithography process" (Xu F. et al. - Proceedings of the spie- The international society for optical engineering spie - Int. Soc. Opt. Eng. USA vol. 5374, no. 1, May 2004, pages 232-241, describe a process for the formation of a pattern on a substrate wherein liquid material is applied in various regions of the substrate so that the total volume of the liquid material is capable to fill the gaps on the mold associated to a template.

EP1254704 shows a system including biopolymer arrays for use in diagnostic, screening, gene expression analysis, and the like, where a material can be delivered according to a multi-drop dispensing scheme.

US2003/001992 describes ejection of materials for color pixels as ink droplets at a predetermining timing corresponding to an array pattern. For example, three patterns can be used: a stripe pattern, a mosaic pattern, and a delta pattern. The ejection amounts satisfy the relationship of the volume for each color in the pattern.

It is desired, therefore, to provide a technique that decreases the time required to fill a feature of an imprint lithography template.

SUMMARY OF THE INVENTION

The present invention is directed to a method for dispensing a total volume of liquid on a substrate according to claim 1.

BRIEF DESCRIPTION OF THE DRAWINGS

Fig. 1 is a perspective view of a lithographic system in accordance with the present invention;

Fig. 2 is a simplified elevation view of a lithographic system shown in Fig. 1;

Fig. 3 is a simplified representation of material from which an imprinting layer, shown in Fig. 2, is comprised before being polymerized and cross-linked;

Fig. 4 is a simplified representation of cross-linked polymer material into which the material shown in Fig. 3 is transformed after being subjected to radiation;

Fig. 5 is a simplified elevation view of a mold spaced-apart from the imprinting layer, shown in Fig. 1, after patterning of the imprinting layer;

Fig. 6 is a top down view showing an array of droplets of imprinting material deposited upon a region of the substrate shown above in Fig. 2 in accordance with a first embodiment of the present invention; and

Fig. 7 is a flow diagram showing a method of dispensing droplets on a region of a substrate as a function of a design of a template.

## DETAILED DESCRIPTION OF THE INVENTION

Fig. 1 depicts a lithographic system 10 in accordance with one embodiment of the present invention that includes a pair of spaced-apart bridge supports 12 having a bridge 14 and a stage support 16 extending therebetween. Bridge 14 and stage support 16 are spaced-apart. Coupled to bridge 14 is an imprint head 18, which extends from bridge 14 toward stage support 16 and provides movement along the Z-axis. Disposed upon stage support 16 to face imprint head 18 is a motion stage 20. Motion stage 20 is configured to move with respect to stage support 16 along X- and Y-axes. It should be understood that imprint head 18 may provide movement along the X- and Y-axes, as well as the Z-axis, and motion stage 20 may provide movement in the Z-axis, as well as the X- and Y-axes. An exemplary motion stage device is disclosed in United States patent application US 2004008334, filed July 11, 2002, entitled "Step and Repeat Imprint Lithography Systems," assigned to the assignee of the present invention, and which is incorporated by reference herein in it's entirety. A radiation source 22 is coupled to system 10 to impinge actinic radiation upon motion stage 20. As shown, radiation source 22 is coupled to bridge 14 and includes a power generator 23 connected to radiation source 22. Operation of system 10 is typically controlled by a processor 25 that is in data communication therewith.

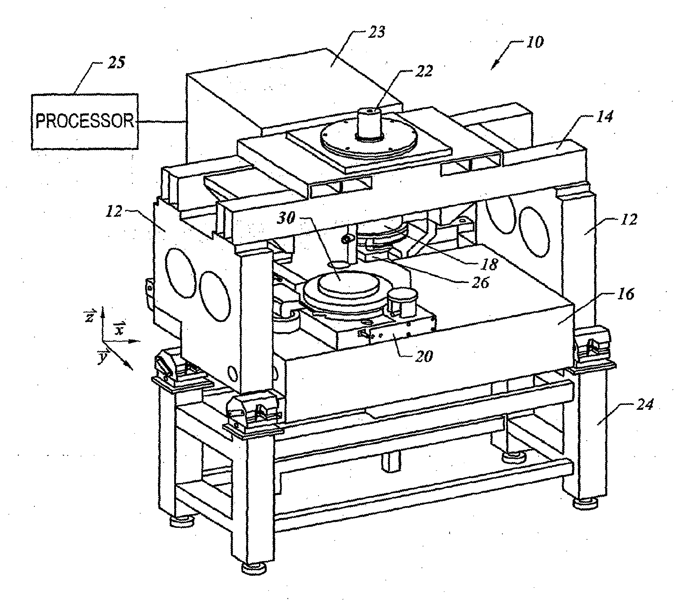

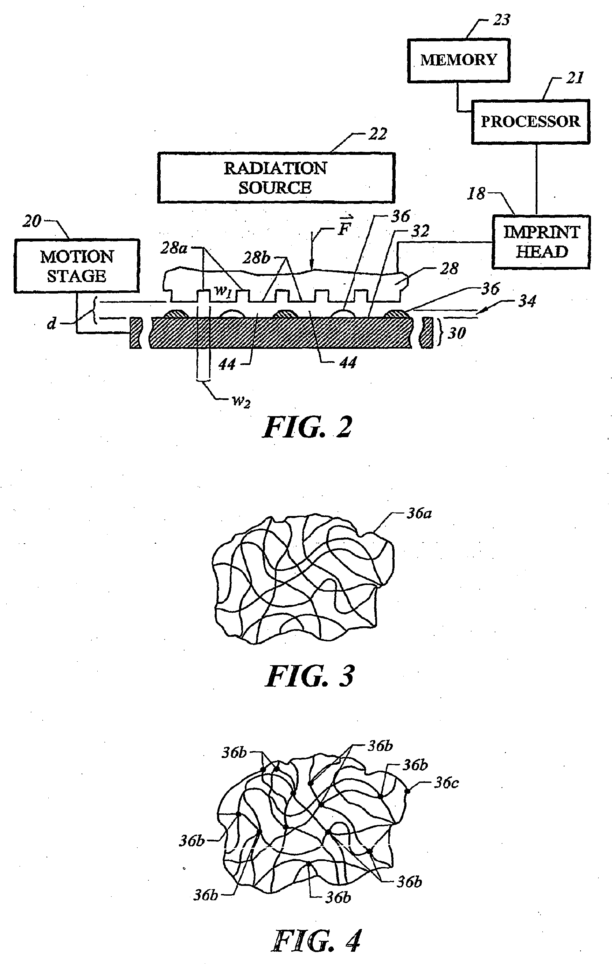

Referring to both Fig. 1 and 2, connected to imprint head 18 is a template 26 having a mold 28 thereon.. Mold 28 includes a plurality of features defined by a plurality of spaced-apart recessions 28a and protrusions 28b. The plurality of features defines an original pattern that is to be transferred into a substrate 30 positioned on motion stage 20. To that end, imprint head 18 and/or motion stage 20 may vary a distance "d" between mold 28 and substrate 30. In this manner, the features on mold 28 may be imprinted into a flowable region of substrate 30, discussed more fully below. Radiation source 22 is located so that mold 28 is positioned between radiation source 22 and substrate 30. As a result, mold 28 is fabricated from material that allows it to be substantially transparent to the radiation produced by radiation source 22. To that end, mold 28 may be formed from materials that includes quartz, fused-silica, silicon, sapphire, organic polymers, siloxane polymers, borosilicate glass, fluorocarbon polymers or a combination thereof. Further template 26 may be formed from the aforementioned materials, as well as metal.

Referring to both Figs. 2 and 3, a flowable region, such as an imprinting layer 34, is disposed on a portion of surface 32 that presents a substantially planar profile. An exemplary flowable region consists of imprinting layer 34 being deposited as a plurality of spaced-apart discrete droplets 36 of material 36a on substrate 30, discussed more fully below. An exemplary system for depositing droplets 36 is disclosed in United States patent application US 2004010341, filed July 9, 2002, entitled "System and Method for Dispensing Liquids," and which is assigned to the assignee of the present invention, and which is incorporated by reference herein in its entirety. Imprinting layer 34 is formed from a material 36a that may be selectively polymerized and cross-linked to record the original pattern therein, defining a recorded pattern. An exemplary composition for material 36a is disclosed in United States patent application US 2005192421, filed February 27, 2004 and entitled "Composition for an Etching Mask Comprising a Silicon-Containing Material," which is incorporated by reference in its entirety herein. Material 36a is shown in Fig. 4 as being cross-linked at points 36b, forming cross-linked polymer material 36c.

Referring to Figs. 2, 3 and 5, the pattern recorded in imprinting layer 34 is produced, in part, by mechanical contact with mold 28. To that end, distance "d" is reduced to allow imprinting droplets 36 to come into mechanical contact with mold 28, spreading droplets 36 so as to form imprinting layer 34 with a contiguous formation of material 36a over surface 32. In one embodiment, distance "d" is reduced to allow sub-portions 34a of imprinting layer 34 to ingress into and to fill recessions 28a.

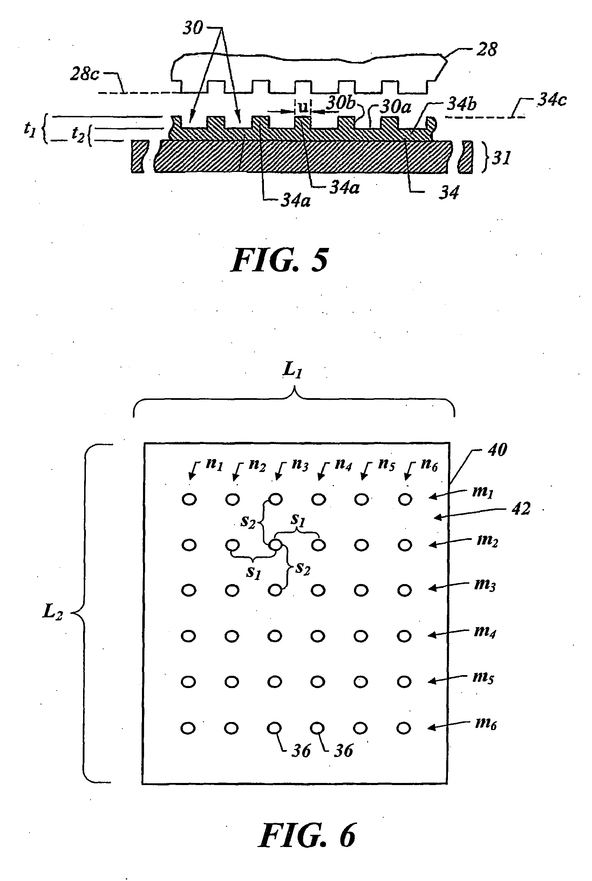

To facilitate filling of recessions 28a, material 36a is provided with the requisite properties to completely fill recessions 28a while covering surface 32 with a contiguous formation of material 36a. In the present embodiment, sub-portions 34b of imprinting layer 34 in superimposition with protrusions 28b remain after the desired, usually minimum, distance "d", has been reached, leaving sub-portions 34a with a thickness $t_1$ and sub-portions 34b with a thickness $t_2$. Thicknesses $t_1$ and $t_2$ may be any thickness desired, dependent upon the application. Typically, $t_1$ is selected such that $t_1 - t_2 \leq 3u$, shown more clearly in Fig. 5. Sub-portions 34b are typically referred to as a residual layer.

Referring to Figs. 2, 3 and 4, after a desired distance "d" has been reached, radiation source 22 produces actinic radiation that polymerizes and cross-links material 36a, forming cross-linked polymer material 36c. As a result, the composition of imprinting layer 34 transforms from material 36a to cross-linked polymer material 36c, which is a solid. Specifically, cross-linked polymer material 36c is solidified to provide side 34c of imprinting layer 34 with a shape conforming to a shape of a surface 28c of mold 28, shown more clearly in Fig. 5. After imprinting layer 34 is transformed to consist of cross-linked polymer material 36c, shown in Fig. 4, imprint head 18, shown in Fig. 2, is moved to increase distance "d" so that mold 28 and imprinting layer 34 are spaced-apart.

Referring to Fig. 5, additional processing may be employed to complete the patterning of substrate 30. For example, substrate 30 and imprinting layer 34 may be etched to transfer the pattern of imprinting layer 34 into substrate 30, providing a patterned surface 34c. To facilitate etching, the material from which imprinting layer 34 is formed may be varied to define a relative etch rate with respect to substrate 30, as desired.

Referring to Figs. 2, 3 and 6, for molds having very dense features, e.g., recessions 28a and protrusions 28b, on the order of nanometers, spreading droplets 36 over a region 40 of substrate 30 in superimposition with mold 28 to fill recessions 28a can require long periods of time, thereby slowing throughput of the imprinting process. To facilitate an increase in the throughput of the imprinting process, droplets 36 are dispensed to minimize the time required to spread over substrate 30 and to fill recessions 28a. This is achieved by dispensing droplets 36 as a two-dimensional matrix array 42 so that a spacing, shown as $S_1$ and $S_2$, between adj.acent droplets 36 is minimized. As shown, droplets 36 of matrix array 42 are arranged in six columns $n_1$-$n_6$ and six rows $m_1$-$m_6$. However, droplets 36 may be arranged in virtually any two-dimensional arrangement on substrate 30. What is desired is maximizing the number of droplets 36 in matrix array 42, given a total volume, $V_t$, of material 36a necessary to form imprinting layer 34. This minimizes the spacing $S_1$ and $S_2$ between adjacent droplets of droplets 36. Further, it is desired that each of droplets 36 in the subset have substantially identical quantities of material 36a associated therewith, defined as a unit volume, $V_u$. Based upon these criteria, it can be determined that the total number, n, of droplets 36 in matrix array 42 may be determined as follows:

$$(1) \qquad n = V_t/V_u,$$

$$(2) \qquad n = n_1 \times n_2,$$

where $n_1$ is that number of droplets along a first direction and $n_2$ is the number of droplets along a second direction. A spacing $S_1$ between adjacent droplets 36 along a first direction, i.e., in one dimension, may be determined as follows:

$$(3) \qquad S_1 = L_1/n_1,$$

where $L_1$ is the length of region 40 along the first direction. In a similar fashion, a spacing $S_2$ between adjacent droplets 36 along a second direction extending transversely to the first direction may be determined as follows:

$$(4) \qquad S_2 = L_2/n_2,$$

where $L_2$ is the length of region 40 along the second direction.

Considering that the unit volume of material 36a associated with each of droplets 36 is dependent upon the dispensing apparatus, it becomes clear that spacings $S_1$ and $S_2$ are dependent upon the resolution, i.e., operational control of a droplet dispensing apparatus (not shown) employed to form droplets 36. Specifically, it is desired that the dispensing apparatus (not shown) be provided with a minimum quantity of material 36a in each of droplets 36 so that the same may be precisely controlled. In this fashion, the area of region 40 over which material 36a in each of droplets 36 must travel is minimized. This reduces the time required to fill recessions 28 and cover substrate with a contiguous layer of material 36a.

Dispensing droplets 36 may be achieved by either dispensing upon an entirety of substrate 30 at one time, or using either a field-to-field dispense technique, disclosed in United States patent application number 10/194,414 that is the subject of United States patent publication number 2004/0008334, the disclosure of which is incorporated by reference herein, or a combination of the two. To that end, the dispense system used may be either a piezo ink jet based technology or a micro solenoid based technology. As a result, the dispense system may be either a single nozzle, a linear array of nozzles, or a rectangular array of nozzles employed to dispense material 36a, with the linear and rectangular array of nozzles comprising greater than 100 individual jets. The nozzle array jets may dispense with a frequency of up to 4kHz. Nozzle array jets are available either with on-off volume control or with gray scale volume control capability, wherein the gray scale volume control capability may dispense volumes ranging from 1 to 42 pico-liters (pL). When employing the field-to-field dispense technique, each nozzle of the nozzle array may dispense substantially the same composition of material 36a, however, in a further embodiment, each nozzle of the nozzle array may dispense differing compositions of material 36a.

Examples of inkjets include the Omnidot available from the Xaar Corporation headquartered in Cambridge, UK and inkjets available from Spectra, a division of the Dimatix Coloration headquartered in Lebanon, New Hampshire. An exemplary nozzle array is a multi-jet nozzle system that includes 126 jets and is sold under the part number XJ126 by Xaar Corporation. Furthermore, an atomization spray process using an ultrasonic spray head to dispense droplets 36 may be employed. Additionally, for material 36a comprising high viscosities, e.g., 20 centipose or greater, the Leopard available from the Xaar Corporation may be employed, wherein material 36a may be heated to reduce the viscosity of the same to a jettable range.

In order to obtain a thin and uniform residual layer, and minimize the time taken to imprint a field, there are several approaches that may be employed in accordance with the present invention.

Referring to Figs. 1-3 and 7, for example, droplets 36 may be dispensed as a function of the design of template 26 and using suitable environmental gas (such as He) to eliminate trapped gases in imprinting layer 34. One embodiment for dispensing material 36a as a function of the design of template 26 is described here. Droplets 36 may comprise a small volume $V_s$, e.g., on the order of 1-1000 pL. First, consider the case of template 26 absent of features. To achieve a given residual layer thickness on substrate 30, at step 100, compute the total volume $V_1$ of material 36a required, assuming that template 26 confines all of material 36a to an active area of template 26. Assuming a grid geometry of 'm' rows and 'n' columns, at step 102, compute 'm' and 'n' such that $m \times n \times V_s = V_1$. Once 'm' and 'n' are chosen, at step 104, identify the polygonal area around each grid point which represents the control region $A_c$ that has an area of approximately the total area of the active field of template 26 divided by $(m \times n)$. At step 106, dispense a volume = $V_s$ at each grid location where template 26 is not recessed (no features) over the control region $A_c$. At step 108, at grid points where the control region $A_c$ is completely recessed on template 26 dispense a volume = $(V_s + A_c \times d)$, where d is the etch depth of template 26. At step 110, at grid points where a portion (say J%) of the control region $A_c$ is recessed on template 26, dispense a volume = $(V_s + A_c \times d \times J/100)$, where d is the etch depth of template 26.

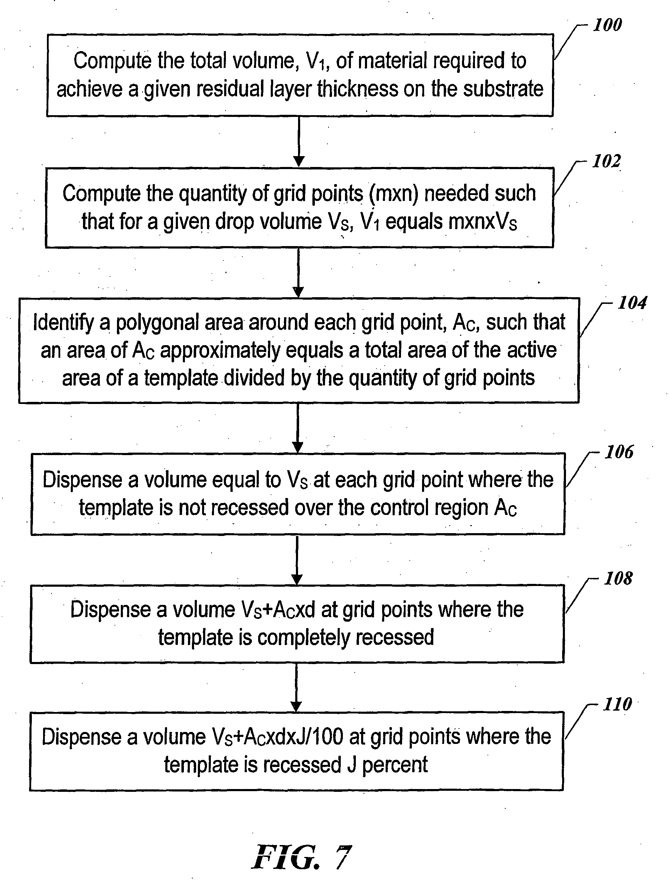

Referring to Figs. 2 and 7, operation of imprint head 18 and the dispensing of droplets 60 may be controlled by a processor 21 that is in data communication therewith. A memory 23 is in data communication with processor 21. Memory 23 comprises a computer-readable medium having a computer-readable program embodied therein. The computer-readable program includes instructions to employ the above algorithm shown in Fig. 7, or something similar to it to calculate the volume to be dispense at each grid point. Such software programs may process template design files (such as a GDS II file) that may be used to fabricate template 26.

Referring to Figs. 2, 3, and 7, the volume to be dispensed at each control region $A_c$ may be achieved by either, for a given volume per droplet of droplets 36, varying a pattern of droplets 36 within each control region $A_c$, or, for a given pattern of droplets 36, varying the volume per droplet of droplets 36 within each control region $A_c$, or a combination of the two. Furthermore, an empirical determination of the drop pattern and/or volume per droplet may be employed to obtain the desired characteristics of a transition region defined between adjacent control regions $A_c$.

The above approach provides the requisite material 36a in a region of substrate 30 while minimizing a distance traveled by material 36a in a droplet of droplets 36 prior to merging with material 36a in an adjacent droplet of droplets 36, and thus, decreasing the time needed for droplets 36 to fill recessions 28a. Upon merger of two or more droplets 36, there is a probability that gas pockets will be generated in imprinting layer 34 proximate to the boundaries of the merging material 36a.

It is desired to minimize the time for droplets 36 to fill recessions 28a, defined as the "fill time" of template 26, while creating imprinting layer 34 substantially absent of voids. To minimize the fill time of template 26, the time required for material 36a to displace the aforementioned gas pockets between the merging material 36a may be minimized. To that end, assuming each of droplets 36 comprises substantially the same volume, a mean and a variance of the volume of the gas pockets may be minimized. As a result, the gas pockets may be displaced at a faster rate by merging material 36a. An example of a pattern of droplets 36 to minimize the mean and the variance of the volume of the gas pockets may include, but is not limited to, hexagonal and triangular. Further, it was found that for a residual layer thickness of 30-40 nm or less, the fill time of template 26 was acceptable.

Additionally, minimizing the aforementioned distance traveled by material 36a in a droplet of droplets 36 prior to merging with material 36a in an adjacent droplet of droplets 36 reduces a viscous drag of material 36a resulting in a greater velocity of material 36a and a greater force to displace the gas pockets, and thus, further minimizing the fill time of template 26. Furthermore, were the gas pockets small volume regions, on the order of microns in lateral dimensions and submicron in thickness, the gas pockets may rapidly dissipate allowing for a fast imprint process.

To further minimize the fill time, a rate of displacement of the gas pockets may be increased such that the merging material 36a may displace the same at a faster rate. To that end, the rate of displacement of the gas pockets is proportional to a hydraulic pressure exerted on the same. The hydraulic pressure may be a function of a capillary force and any external force applied to droplets 36. To increase the hydraulic pressure, the capillary force may be increased, wherein the capillary force may be maximized by minimizing thickness $t_2$, shown in Fig. 5.

It should be noted that the volume dispensed in droplets 36 vary as a function of temperature. For example, the viscosity of material 36a may change, as well as the dimensions of the PZT material that actuates the pump that causes material 36a to egress from a nozzle, both of which vary the volume in a given droplet of droplets 36. Piezo micro-jets may include an in-built temperature sensor, as is the case with Xaar's 126 linear array, which continuously controls the temperature of the pump. A calibration curve that relates temperature and voltage can be developed to maintain a particular volume output. This calibration curve can be used in real-time to adjust the voltage level as temperature variations are observed.

Additionally, to avoid sporadic failure leading to missing droplets 36, a dispensing technique may be employed in which a subset or each droplet of droplets 36 is formed by dispensing of material 36a multiple times in a common location from a nozzle so that in the aggregate, each of droplets 36 is provided with a desired volume. Specifically, the volume of a given droplet of droplets 36 may be an average of the multiple volumes dispensed from the nozzle at the common location.

Further, for a given region on substrate 30, multiple droplets 36 coalesce in such a manner that the droplet local film thickness is an average of over N droplets 36, thereby if 1 droplet of droplets 36 never gets dispensed, then the local film thickness is (desired film thickness/N) nm different from ideal. Therefore, as far as N is sufficiently high (say 100), then the effect of a missing droplet of droplets 36 becomes negligible. As an example, for a field size of X mm by X mm, to establish a 100 nm residual layer, the minimum volume required is $(0.1 \times X^2)$ nL, wherein template 26 has no features in it. If template 26 comprises features, more material 36a would be needed, thereby further increasing N. Therefore, the case of template 26 absent of features is the worst case. The piezo jets can provide a volume as low as 1 pL. If we assume 80 pL as our basic drop unit, then the RLT error in nm is inversely proportional to the square of the characteristic length of the field size - $l_f$ - in mm (defined as square root of the field area in mm$^2$ to include polygonal field regions). This is shown as follows:

If the allowable film thickness variation is 5 nm due to a missing droplet of droplets 36, then $l_f$ is approximately 4 mm, which is independent of the resulting thickness of imprinting layer 34.

It should be noted that as the volume of droplets 36 decrease, the effects of evaporation increase. By calibrating the level of evaporation in droplets 36, the dispense volume can be increased to compensate for the evaporation. For example, more material 36a may be needed in regions of substrate 30 where droplets 36 are dispensed first as compared to regions where droplets 36 are dispensed last. Droplets 36 that are dispensed first evaporate more because it takes longer before template 26 and substrate 30 capture the liquid between them.

Referring to Figs. 3 and 5, in a further embodiment, droplets 36 may comprise a surfactant pre-conditioning solution. The surfactant pre-conditioning solution may be employed such that when droplets 36 contact template 26, a portion of the surfactant pre-conditioning solution may adhere thereto. Droplets 36, comprising the surfactant pre-conditioning solution, may be positioned upon substrate 30 in a pattern to decrease the fill time of template 26, employing the methods as mentioned above. However, in a further embodiment, droplets 36 may be positioned upon substrate 30 in a pattern to counteract an accumulation of surfactant that may occur where adjacent droplets 36 merge and to facilitate droplets 36 filling recessions 28a.

In a further embodiment, it may be desired to position an underlayer (not shown) between substrate 30 and droplets 36. The underlayer (not shown) may comprise a composition having a low surface energy interaction with template 26 and a high surface energy interaction with droplets 36. The composition of the underlayer (not shown) may have minimal evaporation rates and a viscosity of approximately 10-100 cps to facilitate spin-on deposition thereof. The underlayer (not shown) and droplets 36 may be miscible, and the underlayer (not shown) may be a solvent for droplets 36.

The embodiments of the present invention described above are exemplary. The invention is limited by the appended claims.


**Claims**

**1.** A method for dispensing a total volume of liquid on a substrate during an imprint lithography process, said method comprising:

      disposing (106, 108, 110) a plurality of spaced-apart droplets (36) on regions of said substrate (30), each droplets having an unit volume associated therewith, with an aggregate volume of said droplets (36) in each region being a function of a volume of a pattern to be formed thereat, **characterized in that** said disposing step comprises:

disposing (106) in those regions where the pattern to be formed has no features, droplets (36) having an aggregate volume dependent upon a thickness of a residual layer to be formed on said region;
disposing (108, 110), in those regions where the pattern to be formed has a feature, droplets (36) having an aggregate volume dependent upon a thickness of a residual layer to be formed on said region and upon a size of a feature to be formed at said region.

2. The method as recited in claim 1 wherein said volume disposed in those regions where the pattern to be formed has a feature is further dependent upon a percentage of said region comprising said feature.

3. The method as recited in claim 1 wherein disposing further includes dispensing a plurality of volumes of a material to form one of said plurality of spaced-apart droplets (36).

4. The method as recited in claim 1 wherein disposing further includes minimizing a spacing between one of said plurality of spaced-apart droplets (36) and an adjacent droplet (36) of said plurality of spaced-apart droplets (36).

5. The method as recited in claim 1 wherein said plurality of spaced-apart droplets (36) has a pattern selected from a group consisting essentially of hexagonal and triangular.

6. The method as recited in claim 1 wherein the droplets (36) comprise a volume on the order of 1-1000 Pico-liters.

**Patentansprüche**

1. Verfahren zur Verteilung eines Gesamtvolumens einer Flüssigkeit auf einem Substrat in einem Imprintlitographieprozess, wobei das Verfahren umfasst:

Aufbringen (106, 108, 110) einer Mehrzahl von beabstandeten Tropfen (36) auf Bereiche des Substrats (30), wobei jeder Tropfen ein Einheitsvolumen dazu gehörig hat, wobei das aggregierte Volumen der Tropfen (36) in jedem Bereich eine Funktion eines Volumens eines Musters ist, das darauf gebildet werden soll, **gekennzeichnet dadurch, dass** der Aufbringschritt umfasst:

Aufbringen (106) von Tropfen (36), die ein aggregiertes Volumen haben abhängig von einer Dicke einer Restschicht, die auf besagtem Bereich gebildet werden soll, in jenen Bereichen, wo das Muster, das geformt werden soll, keine besonderen Merkmale hat;
Aufbringen (108, 110) von Tropfen (36), die ein aggregiertes Volumen haben abhängig von einer Dicke einer Restschicht, die auf besagtem Bereich gebildet werden soll, und von einer Größe eines besonderen Merkmals, das auf dem Bereich gebildet werden soll, in jenen Bereichen, wo das Muster, das gebildet werden soll, ein besonderes Merkmal hat.

2. Verfahren gemäß Anspruch 1, wobei das Volumen, das in jenen Bereichen aufgebracht wird, wo das Muster, das gebildet werden soll, ein besonderes Merkmal hat, weiter abhängig ist von einem Anteil des Bereichs, der das besondere Merkmal umfasst.

3. Verfahren gemäß Anspruch 1, wobei Aufbringen weiter Verteilen einer Mehrzahl von Volumina des Materials, um einen der Mehrzahl von beabstandeten Tropfen (36) zu bilden, beinhaltet.

4. Verfahren gemäß Anspruch 1, wobei Aufbringen weiter das Minimieren eines Abstands zwischen einem der Mehrzahl der beabstandeten Tropfen (36) und benachbarten Tropfen (36) der Mehrzahl von beabstandeten Tropfen (36) umfasst.

5. Verfahren gemäß Anspruch 1, wobei die Mehrzahl von beabstandeten Tropfen (36) ein Muster ausgewählt aus der Gruppe bestehend aus im Wesentlichen hexagonal und triangular hat.

6. Verfahren gemäß Anspruch 1, wobei die Tropfen (36) ein Volumen im Bereich von 1 bis 1000 Pikolitern haben.

**Revendications**

1.  Procédé pour distribuer un volume total de liquide sur un substrat pendant un processus d'impression par lithographie, ledit procédé comprenant les opérations consistant à :

    disposer (106, 108, 110) une pluralité de gouttelettes espacées (36) sur des régions dudit substrat (30), chaque gouttelette ayant un volume unitaire associé à elle-même, avec un volume cumulé desdites gouttelettes (36) dans chaque région étant une fonction d'un volume d'un motif à former au niveau de celle-ci, **caractérisé en ce que** ladite opération de disposition comprend :

    de disposer (106), dans celles des régions dans lesquelles le motif à former ne présente pas de caractéristiques, des gouttelettes (36) ayant un volume cumulé qui dépend d'une épaisseur d'une couche résiduelle à former sur ladite région ;
    de disposer (108, 110), dans celles des régions dans lesquelles le motif à former présente une caractéristique, des gouttelettes (36) ayant un volume cumulé qui dépend d'une épaisseur d'une couche résiduelle à former sur ladite région et d'une taille d'une caractéristique à former au niveau de ladite région.

2.  Procédé selon la revendication 1, dans lequel ledit volume disposé dans celles des régions dans lesquelles le motif à former comporte une caractéristique dépend en outre d'un pourcentage de ladite région comprenant ladite caractéristique.

3.  Procédé selon la revendication 1, dans lequel ladite opération de disposition inclut en outre de distribuer une pluralité de volumes d'un matériau pour former l'une de ladite pluralité de gouttelettes espacées (36).

4.  Procédé selon la revendication 1, dans lequel ladite opération de disposition inclut en outre de minimiser un espacement entre une gouttelette de ladite pluralité de gouttelettes espacées (36) et une gouttelette adjacente (36) de ladite pluralité de gouttelettes espacées (36).

5.  Procédé selon la revendication 1, dans lequel ladite pluralité de gouttelettes espacées (36) possède un motif choisi parmi un groupe comprenant essentiellement les motifs hexagonaux et les motifs triangulaires.

6.  Procédé selon la revendication 1, dans lequel les gouttelettes (36) comprennent un volume de l'ordre de 1-1000 picolitres.

**FIG. 2**

**FIG. 3**

**FIG. 4**

**FIG. 5**

**FIG. 6**

Compute the total volume, $V_1$, of material required to achieve a given residual layer thickness on the substrate — 100

Compute the quantity of grid points (mxn) needed such that for a given drop volume $V_S$, $V_1$ equals mxnx$V_S$ — 102

Identify a polygonal area around each grid point, $A_C$, such that an area of $A_C$ approximately equals a total area of the active area of a template divided by the quantity of grid points — 104

Dispense a volume equal to $V_S$ at each grid point where the template is not recessed over the control region $A_C$ — 106

Dispense a volume $V_S+A_Cxd$ at grid points where the template is completely recessed — 108

Dispense a volume $V_S+A_CxdxJ/100$ at grid points where the template is recessed J percent — 110

*FIG. 7*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6334960 B, Willson
- WO 0206902 A
- EP 1254704 A
- US 2003001992 A
- US 2004008334 A
- US 2004010341 A
- US 2005192421 A
- US 10194414 B
- US 20040008334 A

**Non-patent literature cited in the description**

- **Xu F. et al.** Development of imprint materials for the step and flash imprint lithography process. *Proceedings of the spie- The international society for optical engineering spie - Int. Soc. Opt. Eng. USA,* vol. 5374 (1), 232-241